# EUROPEAN PATENT SPECIFICATION

(11) **EP 2 128 088 B1**
(45) Date of publication and mention of the grant of the patent: **29.05.2013**
(21) Application number: 08703609.1
(22) Date of filing: 22.01.2008
(51) Int. Cl.: C01B 33/02, C30B 29/06, H01L 31/04, C30B 11/00, C30B 15/00, C30B 15/30, H01L 31/18, C30B 28/10

(54) **APPARATUS AND METHOD FOR MANUFACTURING SILICON SUBSTRATE**
VORRICHTUNG UND VERFAHREN ZUR HERSTELLUNG EINES SILICIUMSUBSTRATS
APPAREIL ET PROCÉDÉ DE FABRICATION D'UN SUBSTRAT DE SILICIUM

(30) Priority: 25.01.2007 JP 2007014629
(43) Date of publication of application: 02.12.2009
(73) Proprietor: Kojima, Gen, Machida-shi Tokyo (JP); Yokoyama, Hiroshi, Hudson, OH 44236 (US)
(72) Inventor: KOJIMA, Gen, Tsukuba-shi Ibaraki 305-8568 (JP); YOKOYAMA, Hiroshi, Tsukuba-shi Ibaraki 305-8568 (JP); HAYASHI, Yutaka, Tsukuba-shi Ibaraki 305-8568 (JP)
(74) Representative: Hall, Matthew Benjamin
(86) International application number: PCT/JP2008/050762
(87) International publication number: WO 2008/090864

(56) References cited:
- EP-A1- 0 070 760
- JP-A- 07 124 707
- JP-A- 08 283 095
- JP-A- 2000 327 490
- JP-A- 2001 031 496
- US-A- 4 319 953

## Description

### Technical Field

The present invention relates to an apparatus and a method for manufacturing silicon substrate used for photovoltaic cell, etc., and the silicon substrate.

### Background Art

The silicon substrate for photovoltaic cell (hereinafter described as Si substrate) is generally classified to single crystalline silicon or multi-crystalline silicon.

Although single crystalline Si substrate is made by means of Czochralski method or zone melting method, the former occupies majority. The obtained Si single crystalline ingot is sliced to Si substrate. Single crystalline Si substrate provides with higher light-electricity conversion efficiency but is produced at high cost and accompanied by the loss of about 50% of Si during the slice of the ingot, which causes the supply shortage of Si substrate in the rapidly increasing demand on a photovoltaic cell.

As more efficient producing method of single crystalline Si substrate, some methods have been proposed such that a long shaped single crystalline Si is obtained by means of horizontal stretch (25-30mm width and 1-2m length single crystal, ref. "10 years progress of the Sunshine Program", p.92), and that the Si meniscus formed between a pair of slender tubes from which the molten Si is welled out is drawn up with seed crystalline ribbon (patent document 1). However, notwithstanding these improved methods, there remains a problem of productivity because the slow speed of single crystalline growth is rate determining.

On the other hand, in order to reduce the cost, manufacturing method for multi-crystalline Si substrate has been developed in place of expensive single crystalline. Multi-crystalline Si substrate is known to be made in general by means of the ribbon method in which the substrate is directly produced from molten silicon and the casting method in which an ingot obtained through cooling and solidifying silicon in a cast is sliced, and a photovoltaic cell in market is produced mainly using the latter.

In order to avoid the contamination of impurity caused by the contact of molten silicon with crucible in the casting method, a method is contrived in which the molten silicon is sustained in non-contact state with crucible by means of electromagnetic induction.

In the case of multi-crystalline Si substrate, the loss of silicon material caused by the slice of ingot is of problem as in the case of single crystalline case. The ribbon method can in principle solve the problem but is not yet completed as a technology to produce efficiently the high quality ribbon applicable to Si substrate.

As manufacturing method of multi-crystalline silicon of sheet form tried by now, method to melt the silicon material by means of IR radiation via light collecting mirror after continuous coating of powder silicon onto carbon fiber substrate of belt form (patent document 2), method to melt the top of the columnar raw silicon to make sheet form silicon by drawing up the molten silicon by use of wire or the like from the slit of lid provided with slit (patent document 3), method to develop the liquid-solid interface of silicon vertical to the surface of molten silicon in sheet like form to bring about the increase of impurity gradation along the vertical direction (patent document 4), method to make a melt zone in raw silicon of sheet form by means of high frequency wave induction heating to make crystalline or purified sheet form silicon (patent document 5), method to prepare a bed of powder of high melting temperature to form thereon silicon layer, on which surface protecting layer is coated next, and make crystallized silicon sheet through melting and crystallizing by continuous zone melting of the silicon layer(patent document 6), similar method to apply the zone melting after preparing silicon layer and top protective layer on a metal layer of low melting temperature as contrary to the preceding case, etc. are known.

Also, a method called RGS (Ribbon Growth on Substrate) (non-patent document 1) has been proposed. This method consists of drawing out continuously silicon ribbon in the form of thin sheet attached to substrate from a slit equipped at the bottom edge of a side wall of a frame where molten silicon is stored, by running the substrate kept at lower temperature than the melting point of silicon under the bottom surface of the frame, and tearing apart the silicon ribbon and the substrate by use of the difference in the shrinkage coefficients of silicon and substrate to obtain the silicon substrate.

However, these methods suffer from the problems in stability as manufacturing method of sheet form silicon, fear of contamination of undesirable impurity and surface state to be caused by the contact to substrate, productivity, etc. and thus any practically adequate manufacturing method for the sheet form silicon is not yet known.

Further, the so-called thin film amorphous silicon photovoltaic cell, in which the amorphous Si is deposited directly onto glass substrate coated with transparent electrode, is used but it holds the subject of the lower light-electricity conversion efficiency and long period stability as compared to the crystalline silicon cell.

On the other hand, as a method to fabricate sheet glass, a method in which molten glass is sustained on steam ("Aqua-float method") and the like are proposed in recent years (patent documents 7, 8). But in the case of expected application of the method to silicon in molten state, the direct application meets the difficulties caused by several factors such as the reaction of silicon with water, the very low viscosity of molten silicon, very high surface tension, sudden change in the properties accompanying the phase transition from the molten to crystalline state.

US 4319953 discloses a method and apparatus for forming Si crystals with columnar structures by casting silicon melt through a gap onto a melt-resistant carrier body with crystallization seed centres.
Patent Document 1: Japanese Patent Application No. 2000-327490
Patent Document 2: Japanese Patent Application No. 1996-283095
Patent Document 3: Japanese Patent Application No. 1997-12394
Patent Document 4: Japanese Patent Application No. 2000-264618
Patent Document 5: Japanese Patent Application No. 1997-12390
Patent Document 6: Japanese Patent Application No. 1997-110591
Patent Document 7: Japanese Patent No. 3948044
Patent Document 8: International Application WO 2006/064674
Non-Patent Document 1: 12th Workshop on Crystalline Silicon Solar Cells, Materials and Process (2002)

### Disclosure of the Invention

The inventors recognize the above described problems of the existing technologies and, aim at the solution of those problems, and a subject of at least the preferred embodiment of the invention is to realize a manufacturing apparatus and method to produce a flat multi-crystalline thin sheet form silicon substrate of large area with low level of undesirable impurity contamination and defect, also enabling thin film forming. Also, a subject of at least the preferred embodiment of the invention is to realize a manufacturing apparatus and method capable of producing a silicon substrate coated with oxide, etc. utilized for a thin film SOI (Silicon On Insulator) that is recently highly expected as an ideal structure directed to offering the high performance of silicon semiconductor devices, etc. with high efficiency, and obtaining the substrate with the oxide coating, etc.

More specifically, a subject of at least the preferred embodiment of the invention is to solve and improve the difficulties of operations and temperature control as well as instabilities observed in the draw down and draw up methods and contamination of impurities through the contact with supporting substrate observed in horizontal drawing, difficulties of temperature control and those of form control. In addition, an object of the invention is to synthesize in one step a composite substrate in which the surface of the silicon substrate is coated with a specific silicon compounds such as oxide, from a molten silicon.

The invention provides an apparatus for manufacturing silicon substrate, wherein the apparatus is arranged with a fabrication bed to which a molten silicon is supplied via an interface which adjusts the molten silicon fed from a silicon melting furnace to the state adequate for the fabrication, and the apparatus fabricates the silicon to a sheet form by preparing a self-sustaining coating in a gas atmosphere inert to the silicon by use of the fabrication bed, and wherein the fabrication bed is provided with plural gas ejecting pores that consist of continuous multi pores of mean pore size of several tens of microns and smaller which eject gas at least to one surface of the molten silicon to be fabricated to the sheet form and plural gas evacuating pores and/or evacuating garters which evacuate the ejected gas from the fabrication bed, and wherein the silicon is fabricated to the sheet form by exerting stretching stress parallel to the silicon surface while maintaining the silicon in a certain constant gas pressure of dynamic stability (dynamic pressure balance state) in a majority of the substrate area formed by the gas ejected from and evacuated into the fabrication bed.

Furthermore, the apparatus of the invention may be characterized in that the interface consists of a contrivance to cause the molten silicon a certain spread by a combination of plural interactions selected from gravity, centrifugal force, interfacial tension, cohesion and shear stress.

Furthermore, the apparatus of the invention may be characterized in that the interface consists of a reservoir which can store the molten silicon at a constant temperature under the existence of the inert gas of a constant pressure lower than an atmospheric pressure, and is provided with an open mouth at the bottom edge.

Furthermore, the apparatus of the invention may be characterized in that the fabrication bed moves at a different speed and/or a different direction from the silicon, oscillates or vibrates in the plane parallel to the silicon to be fabricated into sheet form.

Furthermore, the apparatus of the invention may be characterized in that the fabrication bed is composed of either endless belt, rotating disk, vibrating panel, fixed panel, roller or a combination thereof.

Moreover, the invention provides a method for manufacturing silicon substrate, wherein a molten silicon is fabricated into a sheet form by preparing a self-sustaining coating in a gas atmosphere inert to silicon using a fabrication bed to which molten silicon is supplied via an interface which adjusts the molten silicon to a state adequate for the fabrication, and wherein the silicon is fabricated into the sheet form by exerting stretching stress parallel to silicon surface, while maintaining at least one surface of the molten silicon to be fabricated into the sheet form in a certain constant gas pressure of dynamic stability (dynamic pressure balance state) in a majority of the substrate area formed by the gases ejected from the gas ejecting pores that consist of continuous multi pores of mean pore size of several tens of microns and smaller and evacuated from the gas evacuating pores and/or garters, respectively, which are provided in the fabrication bed.

Furthermore, the method of the invention may be characterized in that the silicon is fabricated to sheet form by controlling the pressure lorded by the silicon and a gas present above the silicon onto the gas which maintains the silicon in such a manner as not to cause sudden change.

Furthermore, the method of the invention may be characterized in that a major component of the gas ejecting from the bed is argon or helium.

Furthermore, the method of the invention may be characterized in that the gas ejected from the fabrication bed contains a volatile substance which includes at least one selected from oxygen, nitrogen and carbon as constituent element, and wherein the fabrication is accompanied by the reaction of the silicon surface with the volatile substance to form a coating.

Furthermore, the method of the invention may be characterized in that the reaction is regulated and controlled by at least one means selected from a concentration and temperature of the volatile substance, a contact time of the volatile substance with the silicon and a temperature of the silicon.

Furthermore, the method of the invention may be characterized in that the temperature distributions in the parallel and vertical direction to the surface of the silicon are adjusted by at least one means selected from a temperature of the substrate surface of the bed, an emmisivity of the substrate, a temperature of the gas, a flow rate of the gas, a radiation heat transfer of the surface of the silicon, a concurrent heat transfer of the surface of the silicon and a transfer speed of the silicon to control a crystalline growth of the silicon.

### Advantage of the Invention

The invention may provide the following advantages.
(1) One advantage is that the surface state of the silicon substrate is clean, flat and smooth as it is constituted of the process to maintain the silicon to be fabricated in the situation of non-contact with solid or liquid.
(2) Another advantage is that the state of the surface, through incorporation of oxygen, water, etc. into the inert gas to be ejected from the substrate, is modified to be provided with self-sustainability to fabricate the silicon and to be able to form simultaneously the coating of silicon oxide, etc. on the surface.
(3) Another advantage is that the shape and performance of the silicon substrate can be improved by controlling the crystalline growth of the silicon ribbon through regulation of temperature distribution parallel and vertical to the surface of the silicon.
(4) Another advantage is that the producing cost of multi-crystalline silicon substrate can be reduced and that the supply shortage can be solved, as the cutting loss of the silicon does not arise and the silicon substrate can be produced simply, with high productivity in large amount, and that it consequently promotes the expanding application of the photovoltaic cell, when applied to the manufacturing of the substrate for the photovoltaic cell, leading to the significant influence on the energy and environmental problems.
(5) Another advantage is that the silicon substrate with oxidized coating applicable to the thin film SOI (Silicon On Insulator) and the like, which are expected as the ideal substrate structure to enhance the performance of silicon semiconductor device, can be produced efficiently at lower cost, urging the possible rapid progress of semiconductor industry and information industry.
(6) Another advantage is that it can be in principle applicable to the manufacturing of substrate of other semiconductor and metal, etc. than multi-crystalline silicon, therefore, together with resource saving and energy saving, an influence to the activation and reinforcement of competitiveness in the field of a broad scope of industry, is expected.

### Brief Description of the Drawings

Fig. 1 is a view illustrating Example 1 for the manufacturing apparatus and method of silicon substrate according to the invention.
Fig. 2 is a view illustrating the main part of Example 1, specifically the constitution of the substrate with (a) cross section and (b) overview.
Fig.3 is a view illustrating the main part of Example 1, specifically the constitution and function of the part just below of the molten silicon feeding mouth.
Fig. 4 is a view illustrating Example 2 according to the manufacturing apparatus and manufacturing method of the silicon substrate of the invention, showing the whole constitution of the manufacturing method and manufacturing apparatus of the silicon substrate by use of spin coating.

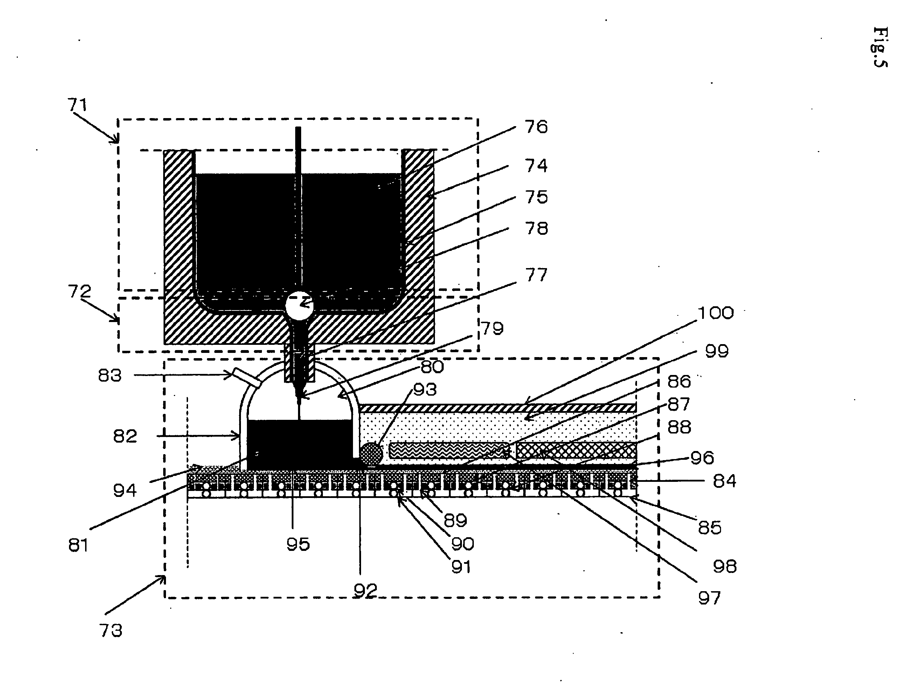

Fig. 5 a view illustrating the main part of Example 3 (side view of the main part).

### Description of the notation

1 Feeding part of molten silicon
2 Molten silicon
3 Rotating roller
4 Fabricated silicon ribbon
5 Belt conveyer for fabrication (fabrication bed)
6 Argon gas containing layer
7 Belt conveyer for annealing (annealing bed)
8 Argon gas layer
9, 10 Gas ejecting and evacuating machine
11 Substrate
12 Silicon ribbon
13 Substrate surface
14 Sustaining portion of silicon ribbon width
15 Wall to prevent the overflow
16 Pressure cell for gas ejecting
17 Gas evacuating pipe
18 Gas evacuating cell
19 Gas ejecting surface
20 Gas evacuating hole
21 Feed mouth of molten silicon
22 Fabrication zone
41 Crucible
42 Molten silicon
43 Feed mouth of molten silicon
44 Stopper / non-contact guide
46 Direct contact guide of molten silicon
47 Non-contact spin coater substrate
48 Silicon disk
49 Non-contact stopper
50 Supporting disk of spin coater
51 Rotation axis of spin coater
52 Rotation axis of non-contact guide
53 Cover of non-contact temperature controller
54 Cover of temperature controller
55 Border of Direct contact/non-direct contact guide
56 Silicon cutting machine
57 Interface of guide/spin coater
58 Fabrication zone
71 Melting zone
72 Feed zone
73 Fabrication zone
74 Silicon melting furnace
75 Silicon melting crucible
76 Molten silicon
77 Feed nozzle of molten silicon
78 Feed rate control valve
79 Feeding molten silicon
80 Reservoir of molten silicon
81 Molten silicon in reservoir
82 Wall of reservoir of molten silicon
83 Pressure adjusting mouth
84 Gas float silicon fabrication bed
85 Gas float silicon fabrication unit
86 Gas ejecting and evacuating substrate
87 Gas pressurizing cell
88 Gas evacuating cell
89 Evacuating hole for ejected gas
90 Feed mouth of pressurized gas
91 Recovery mouth of evacuated gas
92 Exit of silicon ribbon
93 Gas ejecting roller
94 Floating gas
95 Bottom part of silicon in reservoir
96 Silicon ribbon
97 Heating temperature adjusting machine
98 Cooling temperature adjusting machine
99 Inert gas
100 Atmosphere adjusting wall

### Best Mode for Carrying Out the Invention

The best mode for carrying out the invention will be explained in the following with reference to examples and drawings. The mode of carrying out the invention is based on the intension that the invention beside the best mode herein exemplified is not excluded.

The fundamental principle of this invention is that the molten silicon which is melted in crucible is fed to the fabrication machine kept in a gas environment inert to silicon, via the interface which adjusts the molten silicon adequate to the fabrication, through a feeding mouth which is designed to enable the constant feed rate at an appropriate temperature for the fabrication of sheet form silicon, to fabricate the sheet form while sustaining the silicon ribbon, etc. in stable state on a thin gas film during the fabrication of through silicon ribbon and disk from the fed molten silicon.

"Silicon ribbon", "silicon disk" and "silicon substrate" herein described mean the silicon of long sheet form in the process of fabrication from the melt state to the product, the expanded disk shaped silicon in the similar fabrication process and the sheet form silicon as product after fabrication, respectively. Also, the meaning of "sheet form" described in this application document includes that of film form of less than several hundred microns.

As the inert gas herein referred, well known argon, helium, etc. of the so-called rare gas can be adequately applicable. Also, as the melting means, the furnace of not only the ohm resister heating type, but also the electro-magnetic induction heating type, etc. can be applied.

Further, the concrete constitution and method according to the principle of this invention is explained in the following. This invention is a method wherein a fabrication machine with a gas atmosphere inert to high temperature silicon is provided, and to the surface of a fabrication bed covered with a substrate with a function of ejecting a gas by pressure over the entire surface thereof slowly and constantly and evacuating the gas outside, molten silicon is supplied at a suitable temperature higher than the melting point with a constant feed rate (the "continuous" method) or a constant amount (the "batch" method) via an interface which adjusts the molten silicon fed from a silicon melting furnace to the state adequate for the fabrication, the silicon is maintained stably by the dynamic pressure balance formed by a gas that covers the substrate in such a form of thin layer between the silicon (silicon ribbon or silicon disk) and the substrate, and the silicon is fabricated into a sheet form by exerting an external stretching stress parallel to silicon surface to the maintained silicon. The invention is also an apparatus to realize the method.

Silicon in the molten state is difficult to fabricate to sheet form ribbon if supplied to the fabrication bed directly from the silicon furnace because of the low viscosity and high surface tension, and consequently the intervention of some contrivance and machine to adjust the silicon state adequate to the fabrication with the least damage to the features of silicon is necessary. The machine which is provided between the supplying machine and fabricating machine to make the above described state adjustment, concretely saying, the machine which has the contrivance to make the molten silicon have certain spread by means of the control of the temperature, flow rate, etc. is called herein as the "interface".

The dynamic pressure balanced state herein referred means the pressure balanced state which is formed by the gas ejecting slowly and at a constant stationary flow rate into the system from a group of gas ejecting pores provided on the surface of the substrate with a certain distribution pattern and the gas evacuating slowly and at a constant stationary flow rate out of the system through a group of gas evacuating pores provided similarly on the surface of the substrate with a certain distribution pattern.

The inventors found as result of an intensive research and development that it is possible to sustain the silicon without having it contact to solid or liquid during the fabrication process of the silicon substrate from molten silicon to be able to fabricate the silicon to sheet form by means of such constitution and method, and achieved the invention.

In accord with the above description, molten silicon is fed via the interface onto the substrate on fabrication bed to be fabricated to the sheet form by exerting the necessary and adequate stress, where the stress to be exerted to the silicon is the application of tensile stress parallel to the plane of silicon ribbon or silicon disk.

As the concrete ways of exerting the tensile stress, those to use machinery tools such as stretching roller, gear roller, pinch roller, etc. those to use the gravity, those to use centrifugal force, those to use fluid dynamic interaction such as Cuette flow, and so on can be applied.

The pressurized ejecting gas from the gas ejecting pores of substrate is the gas inert to silicon, such as argon, helium, etc. and, when necessary, the appropriate inclusion of volatile substance comprising of oxygen, nitrogen and carbon as ingredient is possible and useful.

That is to say, especially in case of fabrication of composite silicon thin sheet and thin film, such contrivance is desirable in which the pressurized ejecting gas from the substrate shall include volatile substance composed of at least one species of oxygen, nitrogen and carbon as ingredient and at least one surface of the silicon to be fabricated shall react with the above described volatile substance included in the gas ejected from the substrate to fabricate the complex silicon while sustained on the gas.

As the volatile substance herein referred, various compounds such as oxygen gas, nitrogen gas, air, nitrous oxide, carbon monoxide, water, ammonium, alcohols, etc. can be applied.

When the molten silicon is fed via the interface at a certain temperature and at a certain flow rate onto the substrate which ejects the inert gas, although slit, lip, nozzle and the like which have been used hitherto are applicable to the feeding mouth, those which have the shape of the smallest contact area and least contamination of the material into silicon are desirably used. Also, the so-called skull method is effective, in which the part material of feeding mouth is cooled down to the temperature below the melting point of silicon to make a temperature slope within the silicon flowing through inside of the mouth forcing the cooling to solidification of silicon contacting the part material to allow the feeding of only the central portion.

Although the temperature of the silicon to be fed from the feeding mouth to the fabrication machine may be that above the melting temperature of silicon, that between the melting point and 1500°C is appropriate as the too high temperature may cause the increased influence to the machinery parts and the increased contamination of impurity from the feeding mouth. To decide the optimum temperature to maintain the heat capacity enabling the fabrication handling according to the size, shape, thickness of the substrate to be fabricated, operation condition, etc. is possible and desirable, Also, as for the feeding the molten silicon, either of flowing down from the above, welling up from the below or side-flowing is possible and is expected to be designed and applied appropriately.

The state of molten silicon is, when it is fed onto the gas ejecting substrate at the initial stage of the fabrication to silicon ribbon or disk with the fabrication machine, adjusted to be suitable for the fabrication of silicon in terms of transferring, moment, shape arrangement, temperature including the distribution, pressure, quantity, etc. by means of plural interactions of physical forces such as gravity, pressure, centrifugal force, interfacial tension including surface tension, cohesion, shear stress, etc. In order to accomplish the state adjustment, the interface is composed of the part to receive the feed of the molten silicon from the melting furnace through nozzle, the part to adjust the state of the introduced silicon by the action of the above described physical forces and the part to feed the molten silicon adjusted in the state to the fabrication bed, and there are cases where these parts are independent, combined in a whole or continuously combined.

The above described interface may adopt various shapes and forms as the state adjusting part such as rotating roller, flowing guide, centrifugal force applying guide, vessel of constant pressure, etc.

In addition, when the gravity is used to fabricate the silicon on the fabrication bed, the substrate to sustain the silicon ribbon or disk is desirable to have a certain slope from upstream to downstream. In the case of draw down, the weight of the silicon on the substrate may work at large as the force to draw down the silicon at the upstream according to the partial force relative to the slope providing the thinning. In contrast, in the case of draw up, the silicon at upstream may draw down the silicon at downstream according to the partial force relative to the slope providing the thinning. In either case, the stress to be exerted on the silicon is controllable according to the manner of slope. And there is advantage of having the gravity function 100% without any influence of the friction as the silicon ribbon is sustained on gas and in addition with the freedom of slope degree setting.

In the extension of the method, we have the vertical draw down, where the gas ejecting and evacuating substrate faces to one or both surface(s) of the molten silicon flowing down and to induce the oxidation, etc. of the surface and such procedure may make the fabrication possibly easy and may be useful. And also, the method may be possible and useful, in which the silicon flowing down is hung over rotating roller type substrate to induce the surface reaction and fabrication.

In case of applying the centrifugal force, a certain amount of molten silicon flows down or wells out at the center of disk type substrate provided in the fabrication machine and spread over to the circumference direction by the action of centrifugal force endowed in the interface to bring about the thinning of the silicon disk.

Whereby it is difficult to provide the silicon with the circle motion to be caused by the shear stress with the substrate as the silicon is sustained on gas and, in order to make up it, the acceleration of circle motion of the silicon substrate through stroking effect which is brought about by providing a certain unevenness on the substrate covering a certain distance from the center of the disk type substrate is possible and useful.

The molten silicon has to be treated basically all the time in the environment of inert gas since the time of being in the melting crucible, getting out of the feeding mouth and until the time of being treated on the fabrication machine. The gas to be used adequately as inert gas is usually argon.

However, it is not necessarily easy to sustain such liquid of low viscosity as molten silicon on gas. Especially, when the thickness level of silicon ribbon to be fabricated is several hundred of microns and less, non-conformity between the (low) viscosity, cohesion inside of silicon, surface tension (780mN/m) and the stress, etc. to be endowed to realize the thin sheet arises and the fear that the deformation of silicon ribbon may easily take place leading to the shrinkage of silicon width, growth of wrinkles and rupture and breaking into small pieces increases.

As the result of the inventers' intensive investigation on this point, they have found out the method ("self-sustaining coat forming method") to be able to sustain the molten silicon on gas and at the same time to form on the spot the silicon oxide coating or silicon crystalline coating, etc. (hereinafter abbreviated as silicon oxide coating, etc.) which has the appropriate viscosity, rigidity and high affinity to molten silicon, becoming the sustaining material to prevent the undesirable deformation, and accomplished the enhancement of the invention. The "self-sustaining coat" herein referred means the coat which is useful to sustain a substance stably on gas, consisting of ingredient containing the said substance and having a certain rigidity and viscosity.

The silicon substrate having the silicon oxide coat obtained in this way is, in some applications, possible to be used as it is, or possible to be used after removing the coat by abrading, polishing, chemical etching, etc., and further possible to be used in the state with partially remained silicon oxide at necessary spot by means of partial patterning and etching, etc. In reverse, it is possible and useful to form various semiconductor devices and circuits on the silicon oxide. Especially the application as oxide coated substrate silicon substrate

As described above, the admixing of oxygen containing substance such as oxygen, water, etc. into the inert gas are desirable for the purpose of forming the silicon oxide coat and the like, and the precedent absorption of water in a substrate composed of hydrophilic porous material followed by the generation of steam by the heat of molten silicon in order to have the steam work as oxidizing reactant and sustaining gas as well is also desirable. In such a case, the mixing ratio of inert gas and oxygen, water, etc. is desired to be duly set up according to the various conditions to deal with the molten silicon and the required quality of the resultant silicon substrate as material.

The formation of self-sustaining coat is controllable by adjusting the concentration of reactant in the gas, temperature of the gas, flow rate of the gas, temperature of the silicon, temperature of the substrate, emissivity of the substrate, radiation heat evolution and convection heat evolution from the silicon, and the treatment time.

The substrate is a micro porous material having the continuous multi pores of mean pore size of several tens of microns and smaller, and in a preferred embodiment it has a mean pore size of 10 microns and smaller. These continuous micro multi-pores function as the gas ejecting pores in this invention and the pore structure is designed so as to enable a constant flow rate of the gas ejection independent of the existence of molten silicon on the surface. When the pore size is too small, the resistance to the gas ejection becomes too big to obtain enough flow rate and on the contrary when the pore size is too big, the resistance becomes too small and the existence of the substance (silicon) on the substrate rules the gas ejection, resulting in the difficulty of stable floating sustenance of silicon.

Also, the case where these porous materials are hydrophilic is adequately applicable, as the pre-absorbed water vaporizes to be gas with the heat of high temperature molten silicon. When these porous materials are used, it is useful to provide the due gas evacuating holes and further is allowed to provide the gas evacuating garters. This is because, in the case of porous materials having continuous micro-pores, it becomes difficult to separate the pores for gas ejection and those for gas evacuation in terms of gas flow and the latter is allowed to be larger in size and disposition as compared to the former.

In addition, as other substrate having gas ejecting pores and gas evacuating pores with different constitution than the above described porous material, the one which has small holes (diameter ranging from 0.5 mm to 3 mm) provided with statistically homogeneous distribution of distance ranging from 5 mm to 10 mm and the inert gas is ejected at slow and constant flow rate (ranging from 10 m³/(m²h) to 200 m³/(m²h)) from a group of the small holes and the gas is evacuated from other group of small holes is applicable.

The mechanism to maintain the constant flow rate in the above described substrate is known as the flow regulation by vortex (US pat. No. 6,523,572). But the application of such substrate to the substance in molten state of low viscosity like the molten silicon is not known so far.

Such balance between the ejecting and evacuating flowing gases generates a certain constant gas pressure of dynamic stability (dynamic pressure balanced state) in a majority of substrate area, and makes it possible to sustain stable the substance (silicon) on the gas without contact to substrate. In this case, the gas ejection and evacuation of constant flow rate independent of silicon thickness is important and necessary factor.

The material of the substrate is desirable to meet the above described factor and constitution with high thermal, physical and chemical stabilities. And it is desirable that the material has the properties to allow the work into a specific shape and form. From these points of view, carbon, silicon carbide, silica, alumina, cordierite and other ceramics, and molybdenum tungsten and other thermally stable metals are adequately usable, and, in some cases, metals such s steel, SUS, aluminum, etc. can be adequately used. When some reactive substance is included in the inert gas, it is necessary to select the substrate material carefully in terms of the reactivity with the substance. Also, in terms of temperature control, it is possible and useful to consider the emissivity of the substrate surface in the design and preparation.

Further, the silicon in molten state is, as described above, sustained on the gas in the dynamic pressure balance, and, in such case, the maintenance of stable balance between the magnitude of pressure of the gas ejecting from gas ejecting pores of the substrate working vertically to the silicon surface and the sum of the component of the silicon gravity vertical to the silicon surface and the atmospheric pressure on silicon is important to prevent the break of silicon, unnecessary roughness and disordered shape and form.

In principle, the pressure decreases rapidly when the distance between the substrate and silicon increases and, reversely, it increases rapidly when the distance decreases. This leads to a kind of self-stabilization mechanism and consequently the distance between the substrate and silicon is at large kept constant but to set a too high ejecting pressure or amount and/or a big change in the pressure during the fabrication is not desirable for fear of the instability factor.

Although structure of the substrate can be various, it is one of the important technical factors to accomplish thinning of the silicon substrate to obtain and such structure that enables easy fabrication of a certain, constant thickness and easy sustenance as well.

As for the surface shape and form of the substrate, flat plane, entirely semi-cylindrical convex surface and uneven surface having a certain hill and valley structure can be adopted and it is possible and useful to select the most appropriate structure in terms of the combination of the specification of the target silicon substrate and the operation conditions such as temperature, fabrication speed, etc.

Also, the substrate may have the shape and form of roller when the contact time is to be controlled to be shorter. In case of feeding the molten silicon to the rotating roller consisting of the substrate which ejects and evacuates the gas, it is easy to regulate the facing time of the silicon and substrate by adjusting the diameter and/or the surface area of roller and silicon facing. Further, the application of the so-called spin coating method is possible in batch type production.

The fabrication method of this invention is to fabricate the silicon during the cooling process of the molten silicon, while the silicon is transferred, sustained on the dynamic pressure balance state of gas and, in some additional case, accompanied by reaction. In microscopic point of view, the process is non-equilibrium and non-stationary with state change and reaction going on and, in macroscopic point of view, it is non-equilibrium and dynamic stationary in such a case of continuous fabrication.

In such a process like this, the dynamic averaging is important technical factor to attain the macroscopic homogenization and average and, in order to exhibit the dynamic averaging effect, it is desirable to have the substrate slide against the silicon ribbon by, for instance, transferring the substrate with different speed and/or different direction with silicon ribbon or disk in the parallel plane with silicon ribbon or disk, or rotate, oscillate or vibrate, etc. providing the constitution and operation condition to realize the minimization of forming of fixed locus and/or pattern. By such dynamic averaging effect onto not only one surface but also both surfaces, the substrate having the smoother surfaces on both sides can be obtained.

It is also important and useful that the constitution, arrangement and distribution of the gas evacuating pores and gas evacuating garters to be provided in the substrate shall be adequately designed and prepared according to the size, thickness, etc. of the silicon substrate to be fabricated.

The temperature, temperature distribution and cooling rate of the silicon ribbon or disk can be controlled by the temperature of substrate, emissivity of substrate, temperature and flow rate of ejecting gas, distance from the substrate, radiation and convection heat evolution, time of facing of the silicon ribbon or disk with the substrate, etc. in addition to the temperature, flow rate and flow velocity of the molten silicon, and is important for the shape, form and the performance improvement of the obtained substrate. In this invention, silicon is sustained on the gas of which the thermal conductivity is low and consequently more strict regulation of temperature and temperature distribution of silicon are possible.

Further, the formation of oxidized coating on both surfaces of the silicon substrate is possible by installing the reactant substance containing gas ejecting substrate on both surface sides of silicon ribbon or disk.

It is desirable to control the gas flowing along the silicon ribbon or disk to be laminar flow state. Therefore it is desirable to make a scheme to regulate the flow not to generate vigorous ascending current on both of the upper surface and lower surface. In case when the slope of silicon ribbon or disk is steep, it is desirable to provide a control panel for the heat and gas currents.

It is also possible to make the crystalline growth have some certain direction by providing the upper surface and lower surface with the temperature difference thereof. Through such crystalline growth, higher light-electricity conversion efficiency is expected in case of the silicon substrate application to light-electricity conversion device.

A variety of means of drive can be thought of to transfer the silicon to a certain direction, or to stretch the silicon. For instance, in order to make the smooth transfer of silicon in certain direction, a constitution to transfer the silicon with the action of gravity by installing the substrate to have a certain angle declining downward from the horizontal line. Also, the centrifugal force can be used by inducing the circumference spin from a feeding mouth having a certain size of radius.

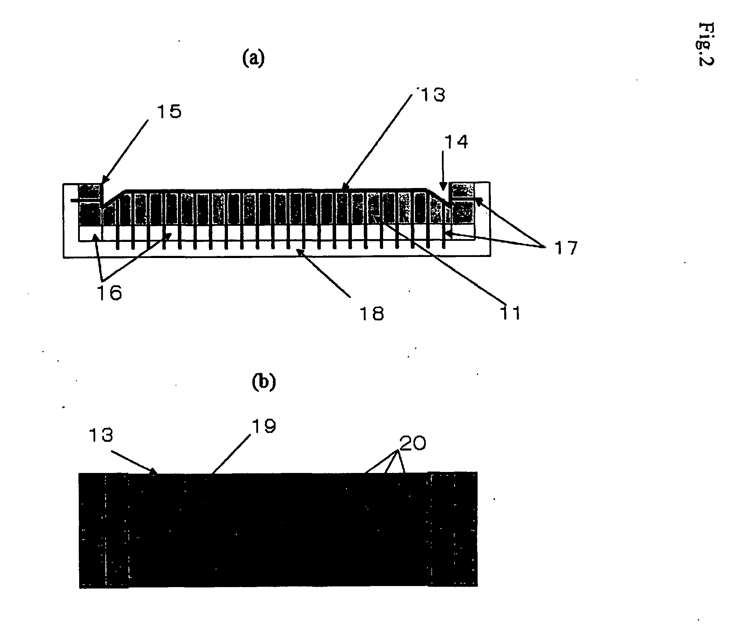

Further, it is possible and useful to make a constitution providing edge corner at both side ends of ribbon to sustain it for the purpose of maintaining the shape of silicon ribbon and the stretching stress across the width of ribbon (Fig.2 (a)).

Further, in regard to the edge corner, it is possible to make the constitution to form the state where the effect of sustenance is enhanced and both of the upper and lower surfaces are coated with the silicon oxide at both of the side edges of silicon ribbon, by sustaining the silicon ribbon from both of the upper and lower surfaces like sandwich by applying the facing edge rollers, which eject inert gas or the gas containing mainly inert gas and partly oxygen including substance, onto the upper surface of silicon ribbon.

Also, it is possible to separate the substrate into several subzones in the fabrication zone to have different functions such as forming of silicon oxide coat, thinning, annealing, cooling, etc.

### [Example 1]

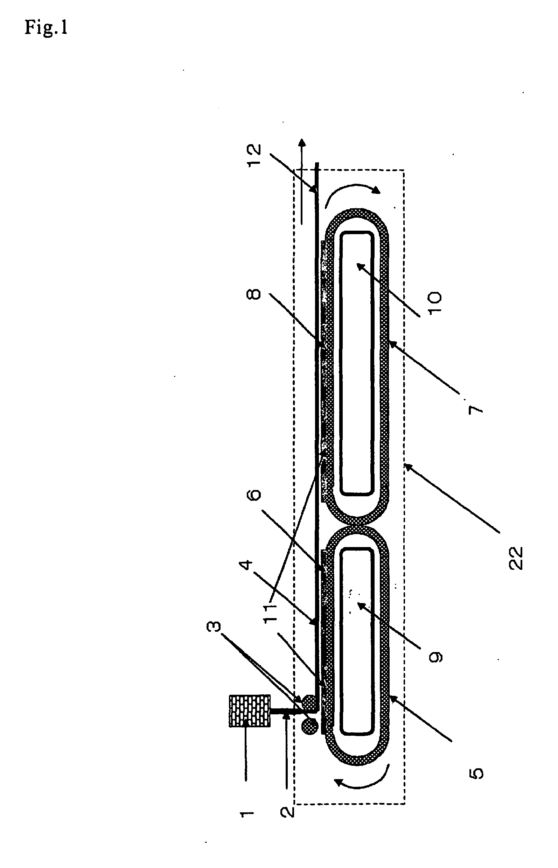

Figs. 1-3 are views illustrating Example 1. Example 1 shows two-stage-conveyer type apparatus which uses the non-contact rotating roller as the interface to adjust molten silicon to the state appropriate for the fabrication. Below the crucible, in the fabrication zone 22, the rotational roller 3, fabrication bed and the adjusting bed (annealing bed) are provided. The fabrication bed and adjusting bed (annealing bed) in example 1 are concretely the belt conveyor 5 for fabrication which consists of the substrate 11 and the belt conveyor 7 for adjustment.

As shown in Figure 1, the molten silicon 2 which is melted in crucible is flown down on the substrate 11 which constitutes the belt conveyor 5 functioning as fabrication bed at a temperature of about 1440 C⁰ from the feed mouth 21 of the feeding part of molten silicon at the crucible, and is continuously transferred downstream while floating on the argon gas layer 6 which covers the surface of substrate 11.

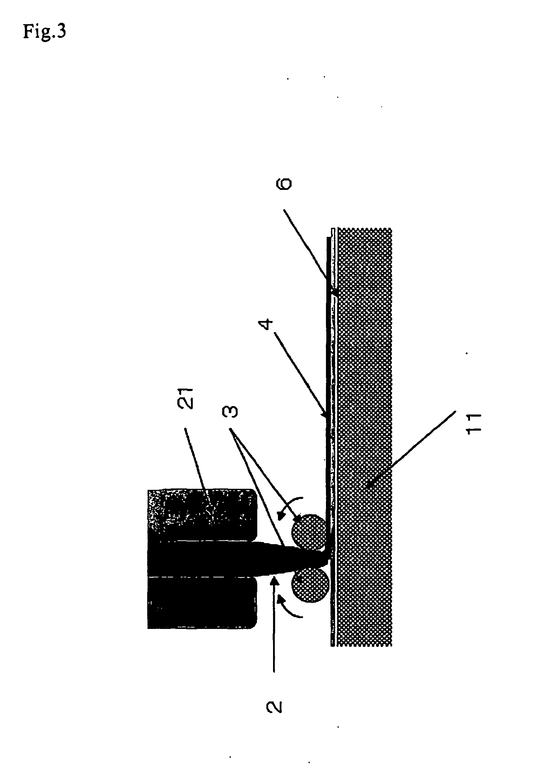

In this occasion, the molten silicon 2 flows down from the feeding mouth 21 with the thickness of about 5 mm and just below there is provided the rotational roller 3 which constitutes of a porous material ejecting argon gas at low rate, as shown in Fig. 3. The argon gas is fed to the rotational roller 3 through the hollow axis which is installed in the center of the roller 3 to rotate it. The rotational roller is set at one side of the molten silicon, if necessary.

The rotational roller 3 can control, in the state of non-contact, the width, thickness, position, etc, of the molten silicon 2 as ribbon, and in addition it can prevent the undesirable ascending current of the surrounding argon and homogenize the temperature of the molten silicon 2 as well.

Further, through the tensile stress exerted to the silicon ribbon 4 by means of gear roller and the like set at downstream (not shown in the drawing), the silicon ribbon 4 on the gas layer 6 composed mainly of argon which is ejected and evacuated from the substrate 11 is continuously fabricated and transferred.

The substrate 11 which constitutes the belt conveyor ejecting and evacuating argon gas is composed of alumina multi-porous material having the micro continuous multi-pores of less than several microns in diameter. Plural numbers of gas evacuating holes 20 are provided and distributed uniformly on the surface 13 of the substrate and those holes are connected, via the gas evacuating tubes 17, to the gas evacuating cell 18 provided at the bottom. The argon gas is ejected from the gas ejecting surface 19 with aperture of micro continuous multi-pores and evacuated from the gas evacuating holes 20, respectively, at constant low flow rate to sustain the silicon ribbon 4 stably thereon through the dynamic pressure balance state.

The pressure, flow rate and flow velocity of the argon gas ejected and evacuated from the substrate surface 13 is adjusted and controlled by the resist load mechanism availed by the vortex flow or the micro pore equipped in or under the substrate. In the case of the substrate shown in Fig.2, the ejection from the gas ejecting surface 19 is of the constitution and scheme to be adjusted and controlled by the resist load mechanism availed by the micro continuous multi-pores and the evacuation from the gas evacuating hole 20 is of the constitution and scheme to be adjusted and controlled by means of the vortex flow resisting portion equipped in the gas evacuating tube 17.

The pressurized argon gas fed to the multi-porous material part of the substrate is supplied from the gas ejecting pressure cell 16 equipped at the bottom of the substrate and the argon gas to be evacuated from the gas evacuating tube 17 is evacuated from the gas evacuating cell 18 equipped at the bottom of gas ejecting pressure cell 16. These gas ejecting pressure cell and gas evacuating cell are connected to the gas ejecting and evacuating machine 9 consisted of pump, etc. so as to enable the supply and recovery of the argon gas without causing trouble in the circulating transfer of belt conveyor 5.

The silicon ribbon 4 sustained in stable state on the dynamic pressure balance of the ejecting and evacuating gas is, according to the necessity, secured at both side edges by means of the silicon ribbon width securing parts (edge corner) 14 prepared at both edges of the substrate 11 as shown in Fig,2 (a) or by means of the overflow preventing wall 15 to prevent the dripping off of the excess silicon to the outside of the system. Gears and rollers and the like can be additionally provided, if necessary, to make the support of silicon ribbon width more certainly.

It is possible to have the argon gas ejecting from the substrate 11 include oxygen or water by the amount ranging from ppm to percent order according to the necessity and form the oxidized coating towards the bottom surface of the silicon ribbon associated with the action of the temperature and time of treatment by the desired thickness level ranging from nanometers to micron meters. As the control factor of the formation of oxidized coating, the concentration of oxygen, etc. can be arranged to a broad range from ppm to percent order (1/1,000,000 to 1/100).

The silicon ribbon 4 fabricated from the molten silicon 2 becomes more stable and easier to exist as continuous ribbon state as it is provided with the stiffness and resultant self-sustainability by means of the above described oxidized coating, and becomes possible to be transferred in uniform by means of the tensile stress given from the downstream and to be further thinned through transformation and renewing in accordance with the thickness of the oxidized coating, the viscosity and stiffness.

The fabricated silicon ribbon 4 is in succession, if necessary, prepared into the desired crystalline silicon substrate 12 through the temperature adjustment on the adjusting bed installed at downstream, while being transferred on the substrate 11 which consists the adjusting conveyor 7.

The substrate 11 which consists the adjusting bed 7 is, similar to the substrate 11 of the fabrication bed 5, provided with the gas ejecting pores and gas evacuating pores, from which the argon gas ejects to the bottom surface of the silicon ribbon 4 to form gas thin layer 8 between the silicon ribbon 4 and substrate 11 and sustains and transfers the silicon ribbon 4 in non-contact state. By this means, the silicon ribbon 4 fabricated in the fabrication zone is manufactured, with the aid of annealing and gradual cooling, as the silicon substrate 12 having the desired crystalline state.

In a series of the operation, in order to fabricate the thickness of silicon ribbon 4 into one tenth of the fed state (for instance 5mm) as molten silicon 2, the silicon ribbon 4 shall be transferred finally at downstream region by 10 times faster than in the state of the feeding. By means of such transfer rate and the length of fabrication machine, the contact time of silicon ribbon 4 with argon gas layer (gas thin layer) 6 can be also controlled.

Temperature of the silicon ribbon 4 can be controlled by means of the combination of temperature of the substrate 11, emissivity of the surface, flow rate of the ejecting gas, temperature of the ejecting gas, the above described contact time, etc. Further, the control becomes still the more efficient by setting panel heater for the temperature adjustment and/or panel for heat insulation in the above space (not shown in the drawing) and the uniformity of the temperature of silicon ribbon 4 can be improved by adjusting the flow rate of the argon gas.

Besides, as described above, the argon gas ejecting from the substrate 11 may contain, according to the necessity, oxygen or water by the amount ranging from ppm to percent order. In such a case, most of the oxygen or water generated from the substrate 11 is expected to react with the silicon but part of them may remain unreacted leaving the fear of being evacuated out of the system. Therefore, a contrivance is necessary to prevent the contamination of the oxygen or water containing gas, which may flow out of the fabrication zone from the below of the bottom surface of silicon ribbon 4 and/or from the substrate 11, into the inert gas covering the upper surface of silicon ribbon 4

As such contrivance, it is desirable to install separator (not shown in the drawing), which prevents the mixing of the gases above and below of the silicon, at around both side edges of silicon ribbon 4 and machine to recover each gas. Concerning the design and installation of the gas separator and recovery machine, the constitution at the point where the molten silicon 2 flows down onto the substrate 11 is the most difficult subject and it can be solved by designing and preparation of such gas recovery devices as the hollow panel provided with tubes towards the top and/or plural holes.

By use of the apparatus described in example 1, complex silicon substrate of the thickness ranging from more than 10 microns to less than several mm having silicon oxide coating can be manufactured.

Although a form which constitutes of transferring substrate 11 is exemplified as the continuous manufacturing apparatus of the silicon substrate in the example 1, it is possible to adopt form which constitutes of the substrate 11 to vibrate or to be fixed. Also, various combinations of micro pore and vortex flow as the controlling mechanism of gas ejection and evacuation. As the reactant to be contained by slight amount, nitrogen may be used instead of oxygen, to lead the formation of nitride as coating in such a case.

### [Example 2]

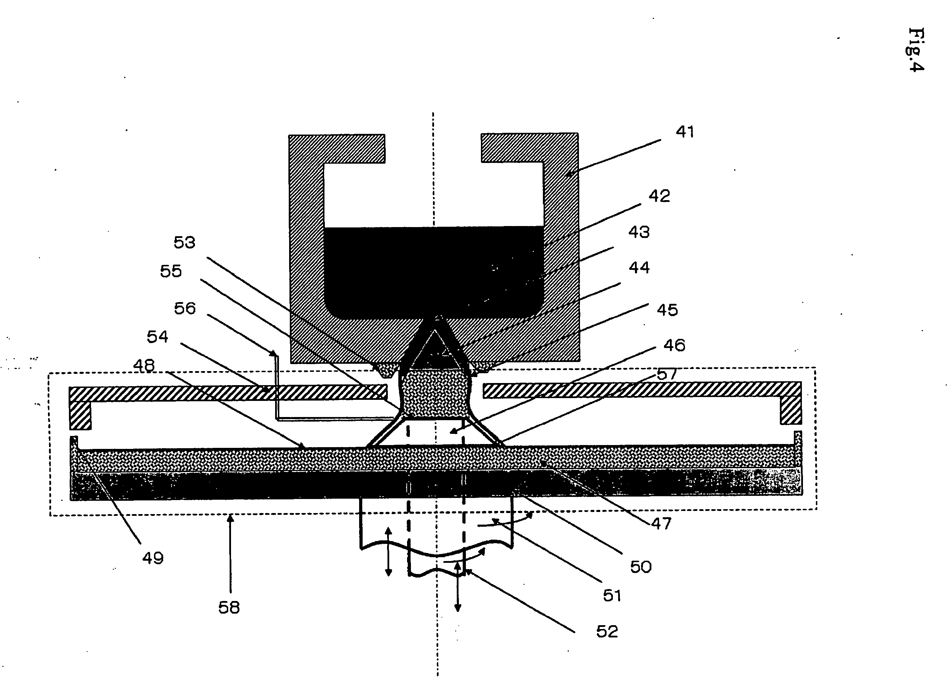

Fig.4 is the drawing to explain the example 2. The example 2 describes apparatus of the type of spin coater using contacting circulation guide as the interface to adjust the molten silicon to be adequate state for the fabrication. The molten silicon 42 melted in the crucible 41 flows down from the feeding mouth 43, between the stopper/non-contact guide 44, and along the guide 44 in non-contact state. The guide 44 constitutes of silica at the top stopper part and of the inert gas ejecting and evacuating cordierite at the bottom guide part.

In the example 2, main part of the fabrication zone 58 to fabricate the silicon substrate consists of the spin coater substrate 47 which is provided on the spin coater supporting plate 50 to be rotated by the spin coater rotating axis 51. Inside the spin coater rotating axis 51 is installed the rotating axis 52 of the same axis for the non-contact guide. At the top of the rotating axis 52 for the non-contact guide is provided the stopper/non-contact guide 44 of molten silicon.

The molten silicon 42 flows down along the rotating guide 44, running down on the contact guide 46 of the molten silicon composed of silicon carbide prepared at the bottom part of the guide 44, to be spread on the non-contact spin coater substrate 47 driven by the centrifugal force given by the rotating contact guide 46.

The flowing down silicon 45 is spread over the non-contact spin coater substrate 47 by means of the centrifugal force given by the guide 46 at the initial stage to, become thin film. On that occasion, the silicon is sustained on the argon gas containing oxygen or water by the amount ranging from ppm to % order to generate simultaneously the oxidation reaction at the surface to form the oxidized coating and self-sustenance which leads to the easier increasing of the centrifugal force and easier thinning. The argon gas, etc is fed through the central axis of rotating disk into the cell provided at the bottom of the disk.

This kind of oxidation reaction is controlled by means of the concentration of the oxygen containing substance to be included in argon gas and the treatment temperature and, in addition, the reaction time can also be adjusted by switching off the oxygen containing substance in the argon gas after a certain time of period to the neat argon. Through these operations, it becomes possible to control the thickness of the oxidized coating ranging from nanometer to micron meter level as is the case with example 1. Also, in order to suppress the mixing of the gases floating over the silicon surface and ejecting from the substrate, a gas curtain comprising of the gas flow along the disk 47 from the center to circumference shall be formed.

In a series of the process, temperature of the silicon is an important factor and it is possible and useful to keep the temperature of the silicon disk 48 overall to be uniform by means of the temperature adjusting cover 54, temperature and emissivity of the non-contact spin coater substrate 47 and the temperature of the gas ejecting from the substrate 47, etc. especially in order to prevent the temperature decrease towards the foremost part which may occur in accordance with the development of the silicon disk 48 on the non-contact spin coater substrate 47. Also, it is occasionally possible to adjust the thickness and shape of the circumference part of silicon disk 48 by the non-contact stopper 49.

Along with these operations, in order to prevent the flow down of the excess molten silicon 42, guide 44 is separated at the border 55 from the contact guide and the below to be raised to stop on blocking up the feeding mouth 43. On that occasion, in order to isolate the silicon disk 48 on the non-contact spin coater substrate 47 from the flowing silicon 45 on the guide 44, these silicon disk 48 and flowing silicon 45 are cut off from each other by means of silicon cutting machine such as laser, etc.

After forming thin film and oxidized coating, silicon disk 48 is treated to make the crystalline growth and annealed accordingly while subjected to the due temperature adjustment, and then the disk is withdrawn together with the rotating axis 51 and further the non-contact guide rotating axis 52 is separated to recover the silicon disk 48 as silicon substrate from the spin coater substrate 47 which loads the silicon disk 48.

On the occasion, the silicon 48 is suitably cut off at the bottom of the molten silicon contact guide 46, if necessary, or may be separated together with the guide part as it is from the guide/spin coater border 57, to use it as product holder.

It is possible to manufacture the complex silicon substrate with the thickness ranging from more than 10 microns to less than several mm by use of this apparatus.

### [Example 3]

Fig, 5 is the drawing to explain the example 3 of the invention. This example shows one stage bed type apparatus to use constant pressure molten silicon reservoir as the interface to adjust the molten silicon to be in adequate state for the fabrication. The apparatus constitutes of the melting zone 71, feed zone 72 and fabrication zone 73.

The melting zone 71 basically consists of silicon melting furnace 74, silicon melting crucible 75 and the molten silicon 76 is stored in the crucible at a constant temperature beyond the melting point.

The above described feed zone 72 basically consists of the feed nozzle 77 of the molten silicon and the valve 78 to adjust the amount of the feeding molten silicon 79. The valve is suitably selected to be used among ball valve, conical valve, butterfly valve, etc. and the material to be used shall be selected to be of less fear of the reactivity with high temperature silicon. The valve, though not described in the drawing, is provided with the contrivance of feedback system to enable the control of molten silicon feeding at the rate corresponding to the pressure inside of the constant pressure reservoir and the fabrication treatment speed.

The above described fabrication zone 73 consists of fabrication bed 84, molten silicon reservoir 80 which is placed on the bed in non-contact state, gas ejecting roller 93 provided towards the bottom part of the reservoir, heating temperature adjusting machine 97, cooling temperature adjusting machine 98, atmosphere adjusting wall 100, etc.

The above described molten silicon reservoir 80 has open face towards the fabrication bed and is covered by reservoir wall 82 towards the side and ceiling provided with the contrivance to feed and withdraw the gas through the pressure adjusting mouth 83 to adjust the inner pressure in order to sustain and adjust the pressure loaded on the upper surface of the temporary stored molten silicon 81 at constant level. In addition, though not described in the drawing, the reservoir has the contrivance to control the composed pressure of the silicon in the reservoir and the gas above to be constant at lower surface of the bottom part of silicon in reservoir 95 through the feedback of the amount of silicon in the reservoir and the fabrication treatment speed, etc.

The above described fabrication bed 84 has the structure composed of the fabrication units 85 being linked together by a certain distance. The said unit 85 is provided with the gas ejecting and evacuating substrate 86 which constitutes the surface, cell 87 to feed the gas to the substrate with pressure at constant rate, evacuating hole 89 to evacuate the gas ejected from the substrate, cell 88 to recover the evacuated gas, together with gas feeding mouth 90 to feed the pressurized gas to the substrate 86 via the gas pressing cell 87 and gas recovering mouth 91 working in similar manner, respectively attached to the corresponding cell, leading to, though not described in the drawing, the contrivance to enable the smooth feed and recovery of the gas via flexible piping to respond the transfer of the bed, according to the necessity.

By use of the apparatus as described in this example, the molten silicon 76 is stored temporarily as molten silicon in the reservoir 81 in constant amount and at constant temperature, and is sustained at the bottom surface by the floating gas 94 which ejects and evacuates from the substrate constituting the surface of fabrication bed 84, and, while forming the self-supporting coating on the surface by means of the reactant, etc. like oxygen which is contained in the floating gas, is withdrawn as silicon ribbon 96 of the constant thickness from the silicon ribbon exit 92 through the space between the substrate 86 and the gas ejecting roller. The silicon ribbon is transferred and fabricated through tensile stress at constant rate given by a device like gear roller, etc. from the right hand side of the drawing, though not described in the drawing.

The silicon ribbon 96 runs out of the reservoir from the exit 92 with the self sustaining coat towards the bottom surface and the molten state silicon towards the top surface, and thereafter the temperature of the ribbon is adjusted and controlled by the temperature regulating machines 97 and 98 so as to provide the silicon ribbon with the targeted crystalline structure. Therein, the pressures inside and outside of the reservoir are adjusted and controlled so that the pressure to the gas on the substrate loaded through the above silicon shall not suffer sudden change. Besides, the room above the surface of the silicon ribbon is arranged of the atmosphere by the inert gas 99.

By use of the apparatus of the example, the complex silicon substrate of the thickness of more than 10 microns and less than several mm can be made. Also, by use of the apparatus of the example, silicon substrate can be made by drawing from the interface as the silicon ribbon having the crystallized coat in the bottom through the temperature control when no reacting substance is included in the silicon sustaining gas.

Although the best mode to realize the manufacturing apparatus and method of the silicon substrate according to the invention is explained as above based on the examples, this invention is not limited by these examples and it will be apparent that there exists other modes for carrying out the invention within the scope of technical aspects of the description in the appended claims.

### Industrial applicability

The manufacturing apparatus of silicon substrate, the manufacturing method and the product thereby obtained, having above described constitution, are applicable to the manufacturing of the silicon substrate, etc. to be used in the applications of photovoltaic cell, high performance silicon semiconductor device and other uses.

## Claims

1. An apparatus for manufacturing silicon substrate, wherein the apparatus is arranged with a fabrication bed (5; 47; 84) to which a molten silicon (2; 42; 76) is supplied via an interface which adjusts the molten silicon fed from a silicon melting furnace to the state adequate for the fabrication, and the apparatus fabricates the silicon to a sheet form by preparing a self-sustaining coating in a gas atmosphere inert to the silicon by use of the fabrication bed, and wherein the fabrication bed is provided with plural gas ejecting pores that consist of continuous multi pores of mean pore size of several tens of microns and smaller which eject gas at least to one surface of the molten silicon to be fabricated to the sheet form and plural gas evacuating pores (20) and/or evacuating garters which evacuate the ejected gas from the fabrication bed (5; 47; 84), and wherein the silicon is fabricated to the sheet form by exerting stretching stress parallel to the silicon surface while maintaining the silicon in a certain constant gas pressure of dynamic stability (dynamic pressure balance state) in a majority of the substrate area formed by the gas ejected from and evacuated into the fabrication bed.

2. The apparatus according to claim 1, wherein the interface consists of a contrivance to cause the molten silicon (2; 42; 76) a certain spread by a combination of plural interactions selected from gravity, centrifugal power, interfacial tension, cohesion and shear stress.

3. The apparatus according to claim 1, wherein the interface consists of a reservoir (80) which can store the molten silicon (81) at a constant temperature under the existence of the inert gas of a constant pressure lower than an atmospheric pressure, and is provided with an open mouth at the bottom edge.

4. The apparatus according to claim 1, wherein the fabrication bed (5; 47; 84) moves at a different speed and/or a different direction from the silicon, oscillates or vibrates in the plane parallel to the silicon to be fabricated into sheet form.

5. The apparatus according to claim 4, wherein the fabrication bed (5; 47; 84) is composed of either endless belt, rotating disk, vibrating panel, fixed panel, roller or a combination thereof.

6. A method for manufacturing silicon substrate, wherein a molten silicon is fabricated into a sheet form by preparing a self-sustaining coating in a gas atmosphere inert to silicon using a fabrication bed (5; 47; 84) to which molten silicon (2; 42; 76) is supplied via an interface which adjusts the molten silicon to a state adequate for the fabrication, and wherein the silicon is fabricated into the sheet form by exerting stretching stress parallel to silicon surface, while maintaining at least one surface of the molten silicon to be fabricated into the sheet form in a certain constant gas pressure of dynamic stability (dynamic pressure balance state) in a majority of the substrate area formed by the gases ejected from the gas ejecting pores that consist of continuous multi pores of mean pore size of several tens of microns and smaller and evacuated from the gas evacuating pores (20) and/or garters, respectively, which are provided in the fabrication bed (5; 47; 84).

7. The method according to claim 6, wherein the silicon is fabricated to sheet form by controlling the pressure lorded by the silicon and a gas present above the silicon onto the gas which maintains the silicon in such a manner as not to cause sudden change.

8. The method according to claim 6, wherein a major component of the gas ejecting from the bed is argon or helium.

9. The method according to claim 6, wherein the gas ejected from the fabrication bed (5; 47; 84) contains a volatile substance which includes at least one selected from oxygen, nitrogen and carbon as constituent element, and wherein the fabrication is accompanied by the reaction of the silicon surface with the volatile substance to form the coating.

10. The method according to claim 9, wherein the reaction is regulated and controlled by at least one means selected from a concentration and temperature of the volatile substance, a contact time of the volatile substance with the silicon and a temperature of the silicon.

11. The method according to claim 6, wherein the temperature distributions in the parallel and vertical direction to the surface of the silicon are adjusted by at least one means selected from a temperature of the substrate surface of the bed, an emmisivity of the substrate, a temperature of the gas, a flow rate of the gas, a radiation heat transfer of the surface of the silicon, a concurrent heat transfer of the surface of the silicon and a transfer speed of the silicon to control a crystalline growth of the silicon.

## Patentansprüche

1. Vorrichtung zum Herstellen eines Siliziumsubstrats, wobei die Vorrichtung mit einem Fertigungsbett (5; 47; 84) versehen ist, dem geschmolzenes Silizium (2; 42; 76) über eine Grenzfläche zugeführt wird, die das geschmolzene Silizium, welches von einem Siliziumschmelzofen zugeführt wird, auf den Zustand einstellt, der für die Herstellung angemessen ist, und wobei die Vorrichtung das Silizium in eine Plattenform durch Herstellen einer selbsttragenden Beschichtung in einer Gasatmosphäre, die inert gegenüber dem Silizium ist, durch Verwendung eines Fertigungsbetts herstellt, und wobei das Fertigungsbett mit mehreren Gasabgabeporen versehen ist, die aus zusammenhängenden Mehrfachporen mit einer mittleren Porengröße von mehreren zehn Mikrometern und darunter bestehen, welche Gas zumindest auf eine Fläche des geschmolzenen Siliziums abgeben, das in die Plattenform gebracht werden soll, und mehrere gasabgebende Poren (20) und/oder Evakuierungsvorrichtungen, die das abgegebene Gas aus dem Fertigungsbett (5; 47; 84) abziehen; und wobei das Silizium in Plattenform durch Einwirkung von Dehnungsspannung parallel zur Siliziumoberfläche hergestellt wird, während das Silizium unter einem bestimmten konstanten Gasdruck von dynamischer Stabilität (dynamischer Druckgleichgewichtszustand) in einem Großteil der Substratoberfläche gehalten wird, die durch das Gas gebildet wird, welches aus dem Fertigungsbett abgegeben und in dasselbe evakuiert wird.

2. Vorrichtung nach Anspruch 1, wobei die Grenzfläche aus einer Einrichtung besteht, mit der bewirkt wird, dass das geschmolzene Silizium (2; 42; 76) eine bestimmte Ausbreitung durch eine Kombination aus Schwerkraft, Zentrifugalenergie, Grenzflächenspannung, Kohäsion und Scherspannung erfährt.

3. Vorrichtung nach Anspruch 1, wobei die Grenzfläche aus einem Vorratsbehälter (80) besteht, der das geschmolzene Silizium (81) bei einer konstanten Temperatur unter dem Inertgas bei einem konstanten Druck lagern kann, der geringer als ein atmosphärischer Druck ist, und der mit einem offenen Ausgang an der Unterkante versehen ist.

4. Vorrichtung nach Anspruch 1, wobei sich das Fertigungsbett (5; 47; 84) mit einer anderen Geschwindigkeit und/oder einer anderen Richtung als das Silizium in der Ebene parallel zum Silizium, das in der Plattenform hergestellt werden soll, bewegt, oszilliert oder vibriert.

5. Vorrichtung nach Anspruch 4, wobei das Fertigungsbett (5; 47; 84) entweder aus einem Endlosband, einer rotierenden Scheibe, vibrierenden Platte, festen Platte, Walze oder einer Kombination derselben besteht.

6. Verfahren zum Herstellen von Siliziumsubstrat, wobei geschmolzenes Silizium zur Herstellung in eine Plattenform gebracht wird durch Herstellen einer selbsttragenden Beschichtung in einer Gasatmosphäre, die inert gegenüber Silizium ist, unter Verwendung eines Fertigungsbetts (5; 47; 84), dem geschmolzenes Silizium (2; 42; 76) über eine Grenzfläche zugeführt wird, welche das geschmolzene Silizium auf einen Zustand einstellt, der für die Herstellung geeignet ist, und wobei das Silizium bei der Herstellung in Plattenform gebracht wird, indem Dehnungsspannung parallel zur Siliziumoberfläche ausgeübt wird, während mindestens eine Oberfläche des geschmolzenen Siliziums, das bei der Herstellung in die Plattenform gebracht werden soll, unter einem bestimmten konstanten Gasdruck von dynamischer Stabilität (dynamischer Druckgleichgewichtszustand) in einem Großteil der Substratoberfläche gehalten wird, die durch die Gase gebildet wird, welche aus den gasabgebenden Poren austreten, die aus zusammenhängenden Mehrfachporen mit einer mittleren Porengröße von mehreren zehn Mikrometern und darunter bestehen, und die aus den gasabgebenden Poren (20) und/oder Evakuierungsvorrichtungen abgezogen werden, welche im Fertigungsbett (5; 47; 84) vorgesehen sind.

7. Verfahren nach Anspruch 6, wobei das Silizium bei der Herstellung in Plattenform durch Steuern des Drucks, der auf dem Silizium ruht, und ein Gas gebracht wird, das oberhalb des Siliziums vorhanden ist, wodurch das Silizium in einer Weise erhalten wird, dass es keine plötzlichen Veränderungen verursacht.

8. Verfahren nach Anspruch 6, wobei eine Hauptkomponente des Gases, das aus dem Bett austritt, Argon oder Helium ist.

9. Verfahren nach Anspruch 6, wobei das Gas, welches aus dem Fertigungsbett (5; 47; 84) abgegeben wird, eine flüchtige Substanz enthält, die mindestens einen Bestandteil enthält, der unter Sauerstoff, Stickstoff und Kohlenstoff als Bestandteil ausgewählt wird, und wobei die Herstellung von der Reaktion der Siliziumoberfläche mit der flüchtigen Substanz begleitet wird, um die Beschichtung zu bilden.

10. Verfahren nach Anspruch 9, wobei die Reaktion durch mindestens ein Mittel reguliert und gesteuert wird, das aus Konzentration und Temperatur der flüchtigen Substanz, Kontaktzeit der flüchtigen Substanz mit dem Silizium und Temperatur des Siliziums gewählt wird.

11. Verfahren nach Anspruch 6, wobei die Temperaturverteilungen in der parallelen und vertikalen Richtung zur Oberfläche des Siliziums durch mindestens ein Mittel eingestellt werden, das aus einer Temperatur der Substratoberfläche des Bettes, einem Emissionsgrad des Substrats, einer Temperatur des Gases, einem Durchsatz des Gases, einer Strahlungswärmeübertragung der Siliziumoberfläche, einer gleichzeitigen Wärmeübertragung der Siliziumoberfläche und einer Übertragungsgeschwindigkeit des Siliziums ausgewählt wird, um ein Kristallwachstum des Siliziums zu steuern.

## Revendications

1. Appareil pour fabriquer un substrat de silicium, dans lequel l'appareil est agencé avec un banc de fabrication (5 ; 47 ; 84) auquel du silicium fondu (2 ; 42 ; 76) est fourni par l'intermédiaire d'une interface qui ajuste le silicium fondu amené en provenance d'un four de fusion de silicium jusqu'à l'état adéquat pour la fabrication, et l'appareil fabrique le silicium en une forme de feuille en préparant un revêtement autoporteur dans une atmosphère de gaz inerte pour le silicium par l'utilisation du banc de fabrication, et dans lequel le banc de fabrication est muni de plusieurs pores d'éjection de gaz qui consistent en pores multiples continus d'une taille de pore moyenne de plusieurs dizaines de microns et moins qui éjectent du gaz vers au moins une surface du silicium fondu à fabriquer en forme de feuille et plusieurs pores d'évacuation de gaz (20) et/ou jarretières d'évacuation qui évacuent le gaz éjecté du banc de fabrication (5 ; 47 ; 84), et dans lequel le silicium est fabriqué à la forme de feuille en exerçant une contrainte d'étirage parallèlement à la surface de silicium tout en maintenant le silicium dans une certaine pression gazeuse constante de stabilité dynamique (état d'équilibre de pression dynamique) dans une majorité de la surface de substrat formée par le gaz éjecté du banc de fabrication et évacué dans celui-ci.

2. Appareil selon la revendication 1, dans lequel l'interface consiste en une adaptation pour amener le silicium fondu (2 ; 42 ; 76) à un certain étalement par une combinaison de plusieurs interactions sélectionnées parmi la gravité, la puissance centrifuge, la tension interfaciale, la cohésion et la contrainte de cisaillement.

3. Appareil selon la revendication 1, dans lequel l'interface consiste en un réservoir (80) qui peut stocker le silicium fondu (81) à une température constante sous l'existence du gaz inerte d'une pression constante inférieure à une pression atmosphérique, et est munie d'une embouchure ouverte au niveau du bord inférieur.

4. Appareil selon la revendication 1, dans lequel le banc de fabrication (5 ; 47 ; 84) se déplace à une vitesse différente et/ou dans une direction différente du silicium, oscille ou vibre dans le plan parallèle au silicium à fabriquer en forme de feuille.

5. Appareil selon la revendication 4, dans lequel le banc de fabrication (5 ; 47 ; 84) est composé soit d'une courroie sans fin, d'un disque rotatif, d'un panneau vibrant, d'un panneau fixe, d'un rouleau soit d'une combinaison de ceux-ci.

6. Procédé pour fabriquer un substrat de silicium, dans lequel du silicium fondu est fabriqué en une forme de feuille en préparant un revêtement autoporteur dans une atmosphère de gaz Inerte pour le silicium en utilisant un banc de fabrication (5 ; 47 ; 84) auquel du silicium fondu (2 ; 42 ; 76) est fourni par l'intermédiaire d'une interface qui ajuste le silicium fondu à un état adéquat pour la fabrication, et dans lequel le silicium est fabriqué dans la forme de feuille en exerçant une contrainte d'étirage parallèlement à la surface de silicium, tout en maintenant au moins une surface du silicium fondu à fabriquer en forme de feuille dans une certaine pression gazeuse constante de stabilité dynamique (état d'équilibre de pression dynamique) dans une majorité de la surface de substrat formée par les gaz éjectés à partir des pores d'éjection de gaz qui consistent en pores multiples continus d'une taille de pore moyenne de plusieurs dizaines de microns et moins et évacués à partir des pores d'évacuation de gaz (20) et/ou des jarretières, respectivement, qui sont prévus dans le banc de fabrication (5 ; 47 ; 84).

7. Procédé selon la revendication 6, dans lequel le silicium est fabriqué en forme de feuille en maîtrisant la pression imposée par le silicium et un gaz présent au-dessus du silicium sur le gaz qui maintient le silicium de façon à ne pas provoquer de changement soudain.

8. Procédé selon la revendication 6, dans lequel un composant principal du gaz s'éjectant du banc est de l'argon ou de l'hélium.

9. Procédé selon la revendication 6, dans lequel le gaz éjecté du banc de fabrication (5 ; 47 ; 84) contient une substance volatile qui inclut au moins une substance sélectionnée parmi l'oxygène, l'azote et le carbone en tant qu'élément constitutif, et dans lequel la fabrication est accompagnée par la réaction de la surface de silicium avec la substance volatile pour former le revêtement.

10. Procédé selon la revendication 9, dans lequel la réaction est régulée et commandée par au moins un moyen sélectionné à partir d'une concentration et d'une température de la substance volatile, d'un temps de contact de la substance volatile avec le silicium et d'une température du silicium.

11. Procédé selon la revendication 6, dans lequel les distributions de température dans la direction parallèle et verticale à la surface du silicium sont ajustées par au moins un moyen sélectionné à partir d'une température de la surface de substrat du banc, d'une émissivité du substrat, d'une température du gaz, d'un débit du gaz, d'un transfert de chaleur par rayonnement de la surface du silicium, d'un transfert de chaleur simultané de la surface du silicium et d'une vitesse de transfert du silicium pour maîtriser une croissance cristalline du silicium.
